# EUROPEAN PATENT APPLICATION

(11) **EP 2 079 168 A2**
(43) Date of publication of application: **15.07.2009**
(21) Application number: 08022367.0
(22) Date of filing: 23.12.2008
(51) Int. Cl.: H03M 9/00

(54) **High speed serializing-deserializing system and method**

(30) Priority: 11.01.2008 KR 20080003376
(71) Applicant: Korea Advanced Institute of Science and Technology, Daejeon 305-701 (KR)
(72) Inventor: Yoo, Hoi-Jun, Daejeon (KR); Kim, Joo-Young, Daejeon (KR)
(74) Representative: Otte & Jakelski Patentanwaltskanzlei

(57) **Abstract**

Disclosed are a high speed serializing-deserializing system and a method thereof. The high speed serializing-deserializing system includes: a serializing unit including a plurality of serializers, generating a strobe signal, and multiplexing and converting N bits of parallel data into serial data; a transmission link transmitting the converted serial data and the strobe signal from the serializing unit; and a deserializing unit including a plurality of deserializers, and converting the serial data from the transmission link into the N bits of parallel data with the strobe signal from the transmission link. When serializing N bits of externally supplied parallel data with a rate of N:1, the N may be set to one of various integers. Although the N is extend to a large number such as 16, 32, and the like, the performance is not deteriorated and serialization-deserialization is possible. Accordingly, a window time per one data may be decreased to reduce a total delay of a serialization, to increase a bandwidth of a link, and to improve the robustness of the serialization-deserialization.

## Description

### BACKGROUND OF THE INVENTION

### Field of the Invention

The present invention relates to a high speed serializing-deserializing system and a method thereof, and more particularly to a high speed serializing-deserializing system enabling serialization-deserialization at high speed using a configurable serializer-deserializer although a serializing rate is high, and a method thereof.

### Description of the Related Art

In general, a network system converts low speed parallel data into high speed serial data for transmitting the data at high speed.

Serializer-deserializer is a device necessary in conversion between parallel data and serial data. In particular, the serializer-deserializer is used to reduce the number of wires or pin resources required to transmit plural bits of parallel data. The serializer functions to convert and transmit the parallel data into the serial data, whereas the deserializer function to receive and convert the serial data into the parallel data.

Serializing-deserilizing (SerDes) technology has been widely used to send a large quantity of data through gigabit Ethernet system, wireless network router, optical communication system, or digital video serial link in order to reduce a system cost, and to reduce the number of interconnection wires in on-chip or the number of interconnection pins between chips for effective implementation.

In the conventional serializing-deserializing circuit, during N:1 serialization and 1:N deserialization, the larger the N value is, the longer a time window that a bit of one data to be transmitted in time multiplexing has is. Accordingly, a total delay of the serialization procedure is significantly increased to reduce a bandwidth of a link. That is, in the conventional serializing-deserializing circuit, as the N value is increased, the performance is significantly deteriorated. This causes a required bandwidth condition in the system not to be satisfied, thereby extremely deteriorating the extension.

### SUMMARY OF THE INVENTION

The present invention has been made in view of the above problems, and it is an object of the present invention to provide a high speed serializing-deserializing system that may robustly perform serialization-deserialization with respect to even large N value at high speed and set the N value to different values such as 8, 16, 32, and the like.

In accordance with an exemplary embodiment of the present invention, there is provided a high speed serializing-deserializing system comprising: a serializing unit including a plurality of serializers, generating a strobe signal, and multiplexing and converting N bits of parallel data into serial data; a transmission link transmitting the converted serial data and the strobe signal from the serializing unit; and a deserializing unit including a plurality of deserializers, and converting the serial data from the transmission link into the N bits of parallel data with the strobe signal from the transmission link, wherein the serializing unit sets a serializing rate with respect to the N bits of parallel data to an integer of a quadruple according to a data signal having the predetermined serializing rate time-divided and deserialized by the plurality of serializers.

Preferably, each of the serializers includes: a pull-up element connected between a first node and an output node and being activated in response to a first corresponding clock signal among a plurality of clock signals; and a pull-down element connected between the first node and the output node and being activated in response to a second corresponding clock signal among the plurality of clock signals.

More preferably, the pull-up element is structured by two serially connected PMOS transistors, and the two PMOS transistors are simultaneously turned on for at least a first predetermined time in response to first corresponding clock signals.

Most preferably, the pull-down element is structured by two serially connected NMOS transistors, and the two NMOS transistors are simultaneously turned on for at least a second predetermined time in response to second corresponding clock signals.

The first corresponding clock signals when the NMOS transistors are simultaneously turned on, have an opposite phase with respect to that of the second corresponding clock signals when the PMOS transistors are simultaneously turned on.

Each of the serializers serializes data output in a section having a corresponding pulse of 1 using a continuous pulse. The deserializing unit extracts a reference time signal from a strobe signal of each serializer and converts the serial data from the transmission link by the plurality of deserializers.

The deserializing unit extracts all edges of an output signal in a time order using three toggle flip-flops extracting each edge information from the strobe signal of the transmission link. The transmission link includes: a data link transmitting the serial data; and a strobe link transmitting a start time signal of serialization.

The serializing unit toggles an output each time signals of the respective serializers are activated and loads the toggled output on the strobe link with the start time signal with respect to each edge, and the deserializing unit extracts an edge of the strobe link through three toggle flip-flops and uses the extracted edge of the strobe link as a reference time of each deserializer.

In accordance with another aspect of the present invention, there is provided a high speed serializing-deserializing method using the high speed serializing-deserializing system the method comprising the steps of: (i) converting N (N is an integer) bits of parallel data into N bits of serial data using a data signal and a strobe signal having a predetermined serializing rate; (ii) transmitting the converted serial data and the strobe signal via a transmission link; and (iii) extracting a reference time signal from the strobe signal to convert the transmitted serial data into the N bits of parallel data, wherein step (i) sets a serialization rate with respect to the N bits of parallel data to an integer of a quadruple according to the data signal having the predetermined serializing rate time-divided and deserialized by the plurality of serializers.

Preferably, step (i) serializes data output in a section having a corresponding pulse of 1 using a continuous pulse. More preferably, step (i) includes a step of toggling an output each time signals of the respective serializers are activated, and loads the toggled output on a strobe link as a start time signal with respect to each edge.

Most preferably, step (iii) extracts a reference start signal from the strobe signal of each serializer and converts and outputs the transmitted serial data through the plurality of serializers. Step (iii) extracts an edge of a strobe link through three toggle flip-flops and uses the extracted edge of the strobe link as a reference time of each deserializer.

In the high speed serializing-deserializing system and method in accordance with the present invention, when serializing N bits of externally supplied parallel data with a rate of N:1, the N may be set to one of various integers. Although the N is extend to a large number such as 16, 32, and the like, the performance is not deteriorated and serialization-deserialization is possible. Accordingly, a window time per one data may be decreased to reduce a total delay of a serialization, to increase a bandwidth of a link, and to improve the robustness of the serialization-deserialization.

### BRIEF DESCRIPTION OF THE DRAWINGS

The objects, features and advantages of the present invention will be more apparent from the following detailed description in conjunction with the accompanying drawings, in which:
FIGS. 1 is a block diagram illustrating a configuration of a high speed serializing-deserializing system in accordance with an embodiment of the present invention;
FIG.2 is a block diagram illustrating a configuration of a configurable serializer of the high speed serializing-deserializing system in accordance with an embodiment of the present invention;
FIG.3 is a circuitry diagram illustrating a 4:1 serializer in accordance with an embodiment of the present invention;
FIG.4 is a waveform diagram illustrating time intervals when respective outputs of the eight 4:1 serializer in accordance with an embodiment of the present invention connect with a final output link;
FIG.5 is a waveform diagram illustrating an STR_OUT signal toggled each time respective STR signals of the eight 4:1 serializers in accordance with an embodiment of the present invention are activated from 0 to 1;
FIGS.6 is a block diagram illustrating a configuration of a deserializer of the high speed serializing-deserializing system in accordance with an embodiment of the present invention;
FIGS.7 is a waveform diagram illustrating operating timing of the deserializer in accordance with the embodiment of the present invention; and
FIG.8 is a flow chart illustrating a high speed serializing-deserializing method in accordance with an embodiment of the present invention.

### DETAILED DESCRIPTION OF EXEMPLARY EMBODIMENTS

Hereinafter, a high speed serializing-deserializing system in accordance with exemplary embodiments of the present invention is described in detail with reference to the accompanying drawings.

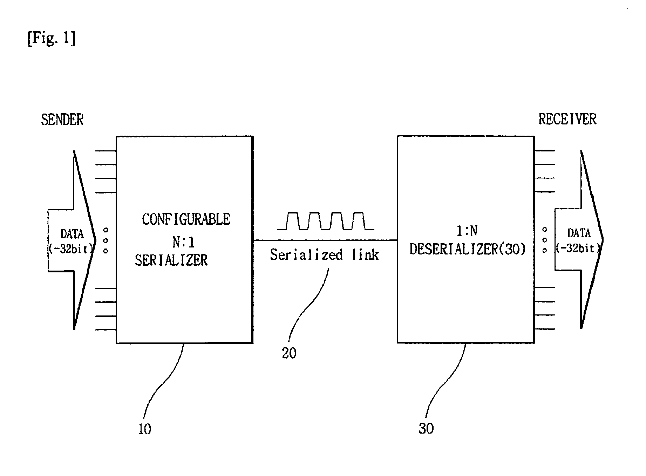

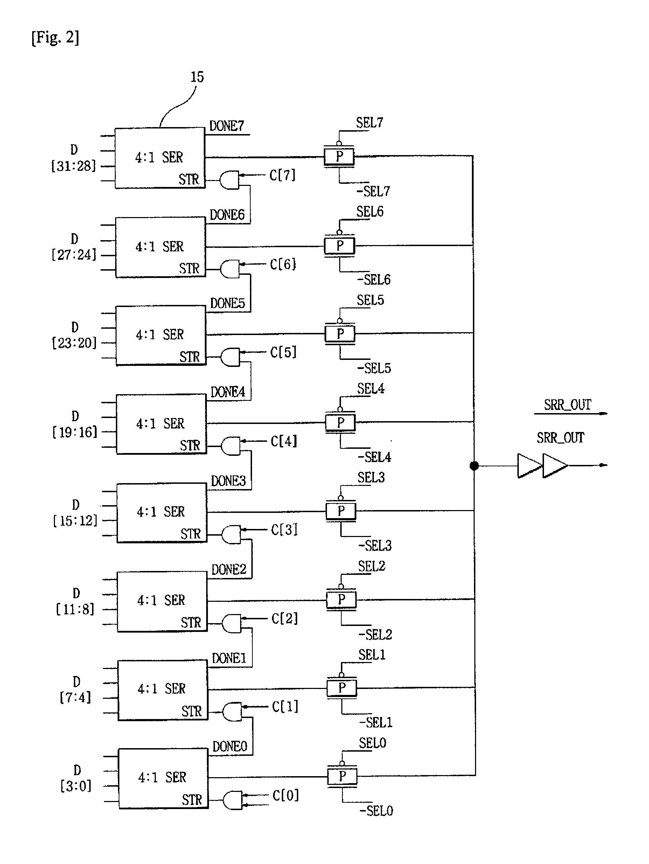

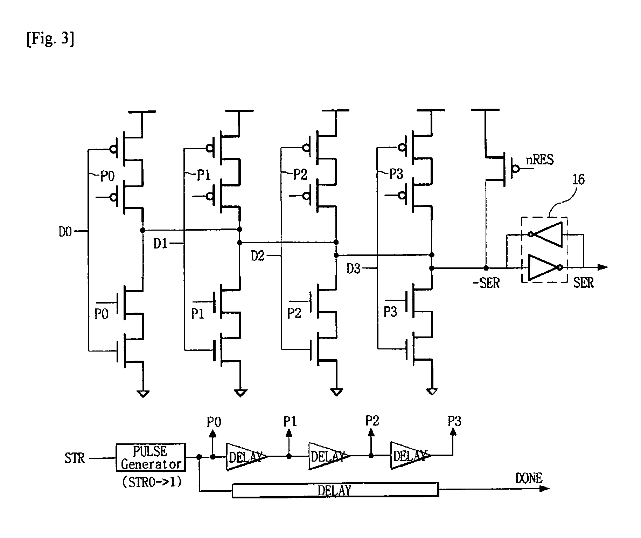

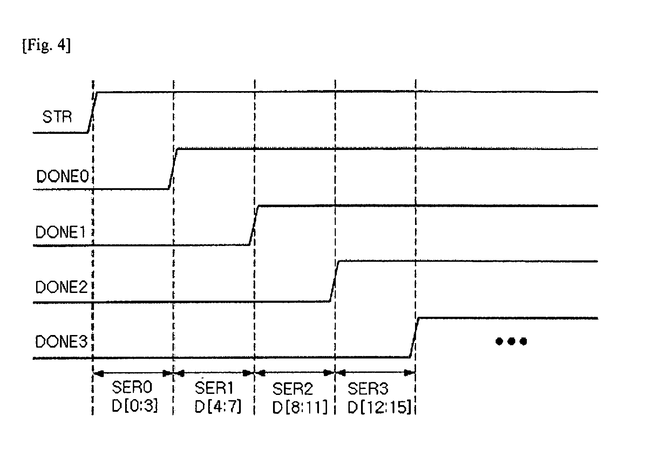

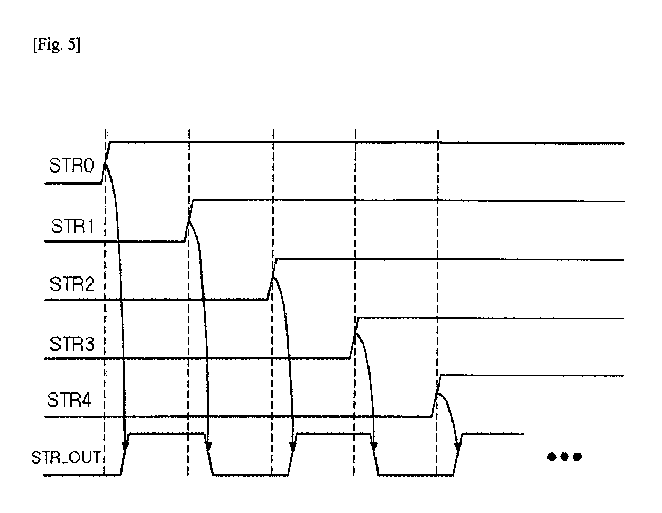

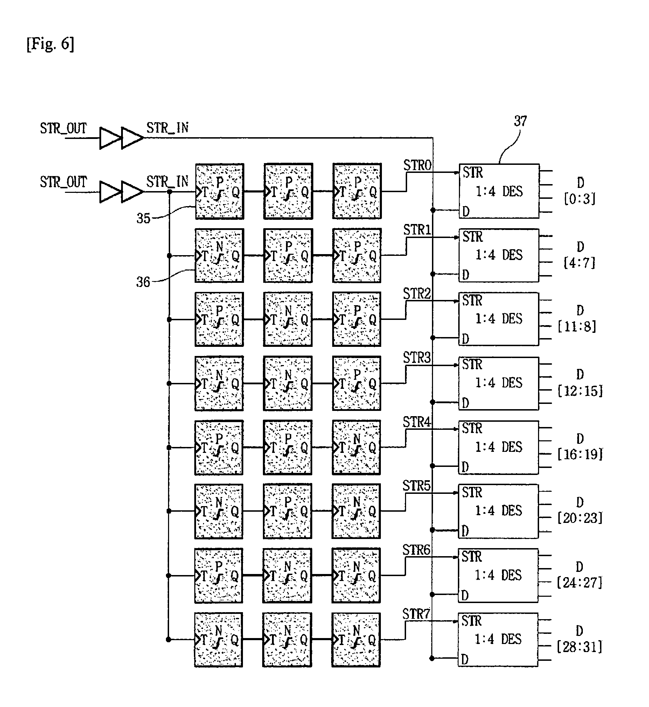

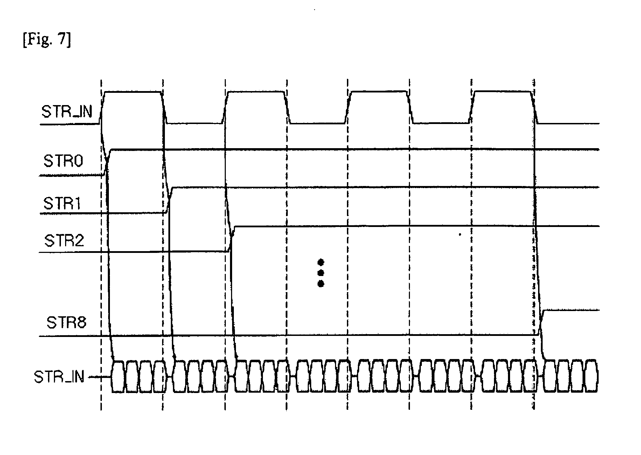

FIGS.1 is a block diagram illustrating a configuration of a high speed serializing-deserializing system in accordance with an embodiment of the present invention. FIG.2 is a block diagram illustrating a configuration of a configurable serializer of the high speed serializing-deserializing system in accordance with an embodiment of the present invention. FIG.3 is a circuitry diagram illustrating a 4:1 serializer in accordance with an embodiment of the present invention. FIG.4 is a waveform diagram illustrating time intervals when respective outputs of the eight 4:1 serializers in accordance with an embodiment of the present invention connect with a final output link. FIG.5 is a waveform diagram illustrating an STR_OUT signal toggled each time respective STR signals of the eight 4:1 serializers in accordance with an embodiment of the present invention are activated from 0 to 1. FIGS.6 is a block diagram illustrating a configuration of a deserializer of the high speed serializing-deserializing system in accordance with an embodiment of the present invention. FIGS.7 is a waveform diagram illustrating operating timing of the deserializer in accordance with the embodiment of the present invention.

As shown in FIG. 1, the high speed serializing-deserializing system in accordance with the present invention includes a configurable N:1 serializing unit 10, a transmission link 20, and a 1:N deserializing unit 30. The configurable N:1 serializing unit 10 has a plurality of serializers, and multiplexes and converts a strobe signal and N bits of externally supplied parallel data into serial data.

The transmission link 20 transmits the serial data and the strobe signal from the configurable N:1 serializing 10.

The 1:N deserializing unit 30 has a plurality of deserializers, and converts the strobe signal and the serial data from the transmission link 20 into parallel data.

In this case, when the N is 32, the serializing unit 10 serializes 32 bits of data from a sender with a rate of 32:1 and transmits the serialized 32 bits of data to a receiver side. A receiver deserializes the serialized 32 bits of data from the serializing unit 10 with a rate of 1:32, and receives 32 bits of restored data.

In addition, upon application of serializing-deserializing technology above described, only one transmission link but not 32 transmission links is required as a connection link between the sender and the receiver.

As shown in FIG. 2, a 32:1 serializer will be now described as an example of configurable serializer of the high speed serializing-deserializing system in accordance with an embodiment of the present invention. The 32:1 serializer has an input signal composed of 32 bits of a data input signal D[31:0], an input signal C[7:0] setting a serializing rate, and a strobe signal STR indicating a start time of serialization. The 32:1 serializer outputs a link serialized with a rate of 32:1 and a strobe signal STR_OUT for deserilaization. The strobe signal functions as a reference signal in an asynchronous link.

Moreover, the configurable 32:1 serializer is composed of eight 4:1 serializers 15 and a pass gate P connecting 8 outputs of the eight 4:1 serializers 15 to one serial link. The 4:1 serializer 15 is a basic block of the serializing unit 10, and functions to convert four parallel data into serial data.

As illustrated in FIG. 3, the following is a description of a circuit structure of the 4:1 serializer shown in FIG. 2. When an input STR signal is 0, the 4:1 serializer does not provide an output. When the input STR signal is activated from 0 to 1, a serializing procedure starts.

When an inversion of the input STR signal from 0 to 1 is sensed, a pulse having a width of approximately 300 ps is generated. Subsequently, four pulse signals P0, P1, P2, and P3 having no overlapped sections with each other are continuously generated. The four pulse signals P0, P1, P2, and P3 are used as P0, P1, P2, and P3 inputs of the 4:1 serializer. Previously prepared data D0, D1, D2, and D3 are output in only a section when the P0, P1, P2, and P3 are 1 to perform time multiplexing.

However, the narrower a time window namely, a pulse width in one bit of data is, the faster the serialization may be performed. However, if the pulse width is too narrow, it is difficult to carry out the deserialization. Accordingly, there is a need for a sufficient pulse width for the serialization-deserialization.

A ∼SER node of the 4:1 serializer outputs - D0 value in a first pulse, ∼ D1 value in a second pulse, - D2 value in a third pulse, and - D3 value in a fourth pulse. An SER obtained by adding an inverter 16 to the ∼SER node becomes a final output. When data is pulled-up from 0 to 1, two serial PMOS transistors for driving the - SER node is used as a pull-up element. When the data is pulled-down from 1 to 0, two NMOS transistors for driving the - SER node is used as a pull-down element. Accordingly, a delay time is always identical with one gate, and the balance between a pull-up delay time and a pull-down delay time may be easily adjusted by sizing the PMOS and NMOS transistors.

In this case, the pull-up element and the pull-down element are connected between a first node to which data are supplied and the - SER node. When the pull-up element and the pull-down element are all turned-on, they have opposite phases with respect to each other.

Such a feature means that an SER signal being a final output may become valid serial data after a short delay of two gates in a pulse signal, and pull-up and pull-down times may be balanced to enable a time window of each bit of data to be suitably maintained at a pulse interval. This provides an advantageous margin during data deserialization.

Meanwhile, since the 4:1 serializer serializes data using pulses and an output node is a dynamic node, it is referred to as 'pulse-dynamic serializer'. Upon termination of serialization, the suggested 4:1 pulse-dynamic serializer outputs a DONE strobe signal representing the termination.

Accordingly, an operation of a 32:1 serializer consisting of eight 4:1 serializers will be now explained.

When an STR signal is activated from 0 to 1, a first 4:1 serializer of the least significant bit (LSB) side operates to serialize D<3:0>, and a link SER0 thereof is output to a final output SER_OUT through a pass gate P.

When the operation of the first 4:1 serializer is terminated, a DONE0 signal is activated to 1. At this time, when an input C[1] for set is 1, a strobe signal of a second 4:1 serializer is activated to start serialization and a corresponding link connects with a final output. However, when the input C[1] is 0, the second 4:1 serializer is not operated. In this manner, serialization to the most significant bit (MSB) side is performed. According to the input C for set, a serializing rate may be 4:1, 8:1, 12:1, 16:1, 20:1, 24:1, 28:1, or 32:1. A following table 1 is serializing rates listed according to input values. In practice, 8:1, 16:1, and 32:1 have been widely used for byte, hard-word, and word data.

**Table 1**

| Input C[7:0] for set | Serializing rate |
|---|---|
| 00000001 | 4 : 1 |
| 00000011 | 8 : 1 |
| 00000111 | 12 : 1 |
| 00001111 | 16 : 1 |
| 00011111 | 20 : 1 |
| 00111111 | 24 : 1 |
| 01111111 | 28 : 1 |
| 11111111 | 32 : 1 |

In the meantime, during a 4:1 serializing procedure being a basic unit in serialization of a high rate, a performance may also be increased using a pulse-dynamic 4: 1 serializer using pulses.

Furthermore, because a serialization rate of a serializing-deserializing circuit may be set in units of 4:1 including 4:1, 8:1, 12:1, 16:1, 20:1, 24:1, 28:1, 32:1, and so forth, serial link transmission by various types of data such as byte, half-word, or word is possible. A following table 2 indicates a summary numerical expression with respect to the performance and features of the serializer according to the embodiment of the present invention.

**Table 2**

| | |
|---|---|
| | Performance and features of the serializer |
| 4:1 serialization | (time window/bit)*4 = 350ps*4 = 1.4ns |
| 32:1 serialization | 1.4ns * 8 =11.2ns |
| Bandwidth of serial link | 32bit / 11.2ns = 2.86 Gbps |
| Serializing rate | Set in units of 4 bits 4:1, 8:1, 12:1, 16:1, 20:1, 24:1, 28:1, 32:1 |

In order to provide outputs of respective activated 4:1 serializers as a final output, control signals SEL0 ∼ SEL7 of pass gates should be exactly determined. For example, an output SER0 of a 4:1 serializer having an input of D[3:0] should be connected to a final output line SER_OUT from a first time to a second time. In this case, the first time is an inverting time of the STR signal from 0 to 1, and the second time is an inverting time of a DONEO signal from 0 to 1. The DONE0 signal is a signal indicating that an operation of a corresponding block is terminated. An STR ? ∼ DONE0 signal is a pulse to have 1 in only the section. The STR ? ∼ DONEO signal is written as a control signal SEL0 of a pass gate P to connect an SER0 to the SER_OUT.

Meanwhile, the control signals of the pass gate P are listed in the following table 3.

**Table 3**

| Control signal of pass gate | Expression |
|---|---|
| SEL0 | STR?∼DONE0 |
| SEL1 | DONE0?∼DONE1 |
| SEL2 | DONE1?∼DONE2 |
| SEL3 | DONE2?∼DONE3 |
| SEL4 | DONE3?-DONE4 |
| SEL5 | DONE4?∼DONE5 |
| SEL6 | DONE5?∼DONE6 |
| SEL7 | DONE6?∼DONE7 |

As shown in FIG. 4, the following is a description of a time interval when respective outputs of the eight 4:1 serializers in accordance with the embodiment of the present invention are a final output link.

So as to again deserialize the serialized data at a receiver end, besides a data output link, a strobe link regarding start time information of serialization is required. Such an output signal is referred to as 'STR_OUT signal'.

Meanwhile, this signal is a substitute of a request signal necessary in an asynchronous link.

However, when the STR_OUT signal is inverted from 0 to 1 at the start time of a 32:1 serializing procedure to provide time information to a receiver end, the receiver end should find out all timing of serialized data received at a predetermined time interval.

Accordingly, when a serialization rate is high like the 32:1 serialization, significant uncertainty may be accumulated and a data sink may be deviated during a deserializing procedure of the serialized data to occur errors.

Accordingly, in the present invention, since one STR_OUT signal has all timing information of the STR signal of respective 4:1 serializers SER0∼SER7 so that a serialization may be performed in units of 4 bits.

The STR_OUT signal toggles an output each time the STR signal of each 4:1 serializer is activated from 0 to 1 so that one STR_OUT signal may have respective STR signals of eight 4: 1 serializers. In this case, a reason why the output may be toggled is because the STR signals of respective 4:1 serializers are generated at predetermined time intervals.

As shown in FIG. 5, the following is an explanation of the STR_OUT signal toggled each time respective STR signals of the eight 4:1 serializers in accordance with an embodiment of the present invention are activated from 0 to 1. Since respective edge signals (both of a positive edge signal and a negative edge signal) contain start time information of the respective 4:1 serializers, deserialization may be performed based on edge information of the STR_OUT signal every 4 bits to have the effect of limiting uncertainty occurring at the deserializing time to the uncertainty of 4:1 conversion in even a case of a high serializing rate such as 32:1.

As illustrated in FIG. 6, the deserializer of the high speed serializing-deserializing system in accordance with the present invention receives the serialized data and the strobe link signal from the serializer as an input, and converts them into 32 bits of parallel data.

In a symmetrical way to the serializer according to the present invention, the deserializer is composed of eight 1:4 deserializers. An activation signal of each 1:4 deserializer is extracted from a strobe link signal STR_IN input to the deserializer.

As illustrated earlier, the strobe link signal is contained in wave information toggled at a start time of each 4:1 serializer. The strobe link signal may extract each edge information using a toggle flip-flop (TFF) as shown in FIG. 6.

An STR_OUT signal output during 32:1 serialization is toggled eight times in total. When the STR_OUT signal is combined with three of positive edge TFTs (P-TFTs) toggled in a positive edge and three negative edge TFTs (N-TFTs) toggled in a negative edge, all edges of the STR_OUT signal may be extracted in a time order.

That is, upon 1:32 deserialization, each edge information is extracted from an STR_IN signal using TFF. A P-TFF 35 toggled at a positive edge and an N-TFF 36 toggled at a negative edge in the STR_IN signal are arranged as shown in FIG. 7 to extract all edges of the STR_IN signal in a time order. All the extracted edges of the STR_IN signal are converted into 32 bits of deserialized data to be output by using eight 1:4 deserializers 37.

FIG. 7 is a waveform diagram illustrating an operation timing of a deserializer in accordance with an embodiment of the present invention. An activation signal of each 1:4 deserializer is extracted from a strobe link signal STR_IN input to the 1:4 deserializer. Respective positive edges and negative edges in the STR_IN are extracted in a time order to be activated to deserialized data every 4 bits. Accordingly, the deserialized data are restored to 32 bits of deserialized data to be output.

Hereinafter, a high speed serializing-deserializing method will be described using a high speed serializing-deserializing system structured as described above in accordance with the embodiment of the present invention.

The high speed serializing-deserializing method in accordance with the embodiment of the present invention includes the steps of: (i) converting N (N is an integer) bits of parallel data into N bits of serial data using a data signal and a strobe signal having a predetermined serializing rate; (ii) transmitting the converted serial data and the strobe signal via a transmission link; and (iii) extracting a reference time signal from the strobe signal to convert the transmitted serial data into the N bits of parallel data. Step (i) sets a serialization rate with respect to the N bits of parallel data to an integer of a quadruple according to the data signal having the predetermined serializing rate time-divided and deserialized by a plurality of serializers.

Step (i) serializes data output in a section having a corresponding pulse of 1 using a continuous pulse. Step (i) includes a step of toggling an output each time signals of the respective serializers are activated, and loads the toggled output on a strobe link as a start time signal with respect to each edge.

Step (iii) extracts a reference start signal from the strobe signal of each serializer and converts and outputs the transmitted serial data through the plurality of serializers. Step (iii) extracts an edge of a strobe link through three toggle flip-flops and uses the extracted edge of the strobe link as a reference time of each deserializer.

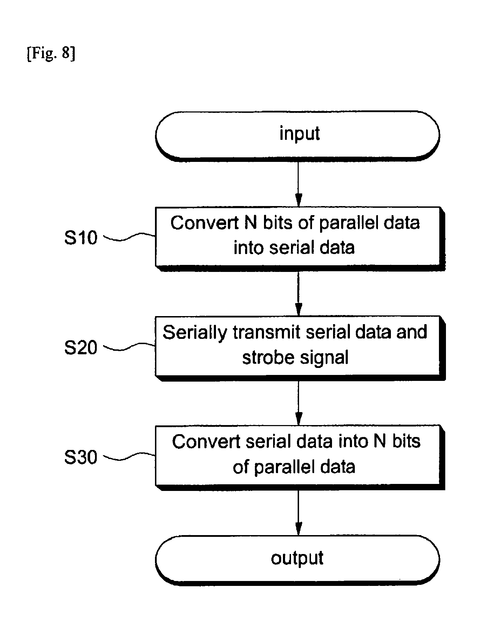

FIG.8 is a flow chart illustrating a high speed serializing-deserializing method in accordance with an embodiment of the present invention. As shown in FIG. 8, the high speed serializing-deserializing method includes the steps of: converting N bits of externally supplied parallel data into serial data (S10); transmitting the converted serial data and the strobe signal via a transmission link (S20); and converting the transmitted serial data from the transmission link into parallel data (S30).

In step S10, a plurality of 4:1 serializers time-divides a strobe signal to serialize, and may set a serializing rate with respect to the N bits of parallel data to an integer of a quadruple, namely, 4:1, 8:1, 12:1, 16:1, 20:1, 24:1, 28:1, or 32:1 according to the data signal having the predetermined serializing rate. Further, an activated output of each 4: 1 serializer is output as a final output using a control signal of a pass gate.

In step S20, the serialized data are transmitted through a data transmission link and start time information of serialization is transmitted through a strobe link.

In step S30, the deserializing unit 30 deserializes the serialized data from the respective 4:1 serializers and one STR_OUT signal with a timing signal of each signal in units of 4 bits.

In this case, since each edge signal of one STR_OUT signal with strobe signals of eight 4: 1 serializers contains start time information of each 4:1 serializer, the respective 4:1 deserilizers are activated according to a strobe link signal STR_IN being an input signal during deserialization, thereby enabling the deserialization every 4 bits.

Therefore, in the present invention, when a serializing rate is high such as 32:1, time division is performed using eight 4 : 1 serializers, thereby reducing load capacitance of each output terminal and an accumulated timing error. Accordingly, the present invention may reduce a window time as compared with the conventional 32: 1 serializing method at one time. Further, because uncertainty such as control signal generation for time multiplexing, asymmetry of a physical implementation, or large load capacitance is limited to uncertainty of 4:1 conversion, performance of serialization-deserialization may be improved.

Although embodiments in accordance with the present invention have been described in detail hereinabove, it should be understood that many variations and modifications of the basic inventive concept herein described, which may appear to those skilled in the art, will still fall within the spirit and scope of the exemplary embodiments of the present invention as defined in the appended claims.

## Claims

1. A high speed serializing-deserializing system comprising:
a serializing unit including a plurality of serializers, generating a strobe signal, and multiplexing and converting N bits of parallel data into serial data;
a transmission link transmitting the converted serial data and the strobe signal from the serializing unit; and
a deserializing unit including a plurality of deserializers, and converting the serial data from the transmission link into the N bits of parallel data with the strobe signal from the transmission link,
wherein the serializing unit sets a serializing rate with respect to the N bits of parallel data to an integer of a quadruple according to a data signal having the predetermined serializing rate time-divided and deserialized by the plurality of serializers.

2. The high speed serializing-deserializing system according to claim 1, wherein each of the serializers includes:
a pull-up element connected between a first node and an output node and being activated in response to a first corresponding clock signal among a plurality of clock signals; and
a pull-down element connected between the first node and the output node and being activated in response to a second corresponding clock signal among the plurality of clock signals.

3. The high speed serializing-deserializing system according to claim 2, wherein the pull-up element is structured by two serially connected PMOS transistors, and the two PMOS transistors are simultaneously turned on for at least a first predetermined time in response to first corresponding clock signals.

4. The high speed serializing-deserializing system according to claim 2, wherein the pull-down element is structured by two serially connected NMOS transistors, and the two NMOS transistors are simultaneously turned on for at least a second predetermined time in response to second corresponding clock signals.

5. The high speed serializing-deserializing system according to claim 3 or 4, wherein the first corresponding clock signals when the NMOS transistors are simultaneously turned on, have an opposite phase with respect to that of the second corresponding clock signals when the PMOS transistors are simultaneously turned on.

6. The high speed serializing-deserializing system according to claim 1, wherein each of the serializers serializes data output in a section having a corresponding pulse of 1 using a continuous pulse.

7. The high speed serializing-deserializing system according to claim 1, wherein the deserializing unit extracts a reference time signal from a strobe signal of each serializer and converts the serial data from the transmission link by the plurality of deserializers.

8. The high speed serializing-deserializing system according to claim 1 or 7, wherein the deserializing unit extracts all edges of an output signal in a time order using three toggle flip-flops extracting each edge information from the strobe signal of the transmission link.

9. The high speed serializing-deserializing system according to claim 1, wherein the transmission link includes:
a data link transmitting the serial data; and
a strobe link transmitting a start time signal of serialization.

10. The high speed serializing-deserializing system according to claim 1 or 9, wherein the serializing unit toggles an output each time signals of the respective serializers are activated and loads the toggled output on the strobe link with the start time signal with respect to each edge, and the deserializing unit extracts an edge of the strobe link through three toggle flip-flops and uses the extracted edge of the strobe link as a reference time of each deserializer.

11. A high speed serializing-deserializing method using the high speed serializing-deserializing system according to claim 1, the method comprising the steps of:
(i) converting N (N is an integer) bits of parallel data into N bits of serial data using a data signal and a strobe signal having a predetermined serializing rate;
(ii) transmitting the converted serial data and the strobe signal via a transmission link; and
(iii) extracting a reference time signal from the strobe signal to convert the transmitted serial data into the N bits of parallel data,
wherein step (i) sets a serialization rate with respect to the N bits of parallel data to an integer of a quadruple according to the data signal having the predetermined serializing rate time-divided and deserialized by the plurality of serializers.

12. The method according to claim 11, wherein step
(i) serializes data output in a section having a corresponding pulse of 1 using a continuous pulse.

13. The method according to claim 11, wherein step (i) includes a step of toggling an output each time signals of the respective serializers are activated, and loads the toggled output on a strobe link as a start time signal with respect to each edge.

14. The method according to claim 11, wherein step (iii) extracts a reference start signal from the strobe signal of each serializer and converts and outputs the transmitted serial data through the plurality of serializers.

15. The method according to claim 11, wherein step (iii) extracts an edge of a strobe link through three toggle flip-flops and uses the extracted edge of the strobe link as a reference time of each deserializer.
